# EUROPEAN PATENT APPLICATION

(11) **EP 4 481 084 A1**
(43) Date of publication of application: **25.12.2024**
(21) Application number: 24164577.9
(22) Date of filing: 19.03.2024
(51) Int. Cl.: C23C 16/448, C23C 16/455, C23C 16/52

(54) **MATERIAL MONITORING SYSTEM, PROCESSING APPARATUS, METHOD OF MANUFACTURING SEMICONDUCTOR DEVICE, AND RECORDING PROGRAM**

(30) Priority: 19.06.2023 JP 2023100365
(71) Applicant: Kokusai Electric Corp., Tokyo 1010045 (JP)
(72) Inventor: GOSHIMA, Kentaro, Toyama-shi, Toyama, 939-2393 (JP)
(74) Representative: Bardehle Pagenberg Partnerschaft mbB Patentanwälte Rechtsanwälte

(57) **Abstract**

There is provided a technique that includes: containers (270A, 270B) accumulating a material, a flow rate controller (241a) controlling a flow rate of the material supplied to a process space (201) where a processing target (200) is placed by regulating an opening state of a control valve; pipes being in fluid communication between the flow rate controller (241a) and the containers (270A, 270B) respectively; open and close valves (243e, 243f) provided at the pipes respectively, and a controller (121) capable of supplying the material to the process space (201) via the flow rate controller (241a) from one container when the opening state of the control valve does not reach a preset threshold, and supplying the material to the process space (201) via the flow rate controller (241a) from two or more containers by opening the open and close valve provided between another container different from the one container and the flow rate controller (241a) when the opening state of the control valve reaches the preset threshold.

## Description

### CROSS-REFERENCE TO RELATED APPLICATION

This application is based upon and claims the benefit of priority from Japanese Patent Application No. 2023-100365, filed on June 19, 2023, the entire contents of which are incorporated herein by reference.

### TECHNICAL FIELD

The present disclosure relates to a material monitoring system, a processing apparatus, a method of manufacturing a semiconductor device, and a program.

### BACKGROUND

In the related art, a semiconductor manufacturing apparatus which manufactures a semiconductor device is known as an example of a substrate processing apparatus. For example, substrate processing is performed in which a processing gas is supplied into a reaction tube and a substrate (hereinafter also referred to as a "wafer") is processed under a predetermined processing condition. In recent years, as the processing gas, various processing gases are used such as gases obtained by vaporizing liquid or gases obtained by sublimating solid. For reasons such as miniaturization of a device in recent years, stably supplying a processing gas while changing a plurality of containers is disclosed, for example, in the related art. In this case, when changing containers, the supply of the processing gas may be interrupted, such that the processing gas may be incapable of being stably supplied to a process chamber.

### SUMMARY

Some embodiments of the present disclosure provide a technique of stably supplying a material in a gaseous state to a process space.

According to some embodiments of the present disclosure, there is provided a technique that includes: a plurality of containers configured to accumulate a material, a flow rate controller configured to control a flow rate of the material supplied to a process space in which a processing target is placed by regulating an opening state of a control valve; a plurality of pipes configured to be in fluid communication between the flow rate controller and the plurality of containers respectively; a plurality of open and close valves provided at the plurality of pipes respectively, and a controller configured to be capable of supplying the material to the process space via the flow rate controller from one container among the plurality of containers when the opening state of the control valve of the flow rate controller does not reach a preset threshold, and supplying the material to the process space via the flow rate controller from two or more containers among the plurality of containers by opening the open and close valve provided between another container different from the one container and the flow rate controller when the opening state of the control valve of the flow rate controller reaches the preset threshold.

### BRIEF DESCRIPTION OF DRAWINGS

The accompanying drawings, which are incorporated in and constitute a part of the specification, illustrate embodiments of the present disclosure.
FIG. 1 is a longitudinal cross-sectional view showing a schematic configuration of a process furnace of a substrate processing apparatus according to embodiments of the present disclosure.
FIG. 2 is a schematic transverse cross-sectional view taken along line A-A in FIG. 1.
FIG. 3 is a block diagram of a control system of a controller showing a schematic configuration of a controller of a substrate processing apparatus according to embodiments of the present disclosure.
FIG. 4 is a flowchart of a substrate processing process according to embodiments of the present disclosure.
FIG. 5 is a schematic diagram showing a configuration of a precursor monitoring system of a substrate processing apparatus according to embodiments of the present disclosure.
FIG. 6A is a diagram showing a state at the start of supply of a precursor gas, FIG. 6B is a diagram showing a state in which a remaining amount of a precursor container 270A decreases from the state of FIG. 6A and an opening state of a control valve of a MFC 241a exceeds a threshold, and FIG. 6C is a diagram showing a state when a predetermined time elapses from the state of FIG. 6B.
FIG. 7 is a diagram which explains flow rate control of a precursor monitoring system according to embodiments of the present disclosure.
FIG. 8 is a diagram which explains flow rate control of the precursor monitoring system according to embodiments of the present disclosure.

### DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components have not been described in detail so as not to unnecessarily obscure aspects of the various embodiments.

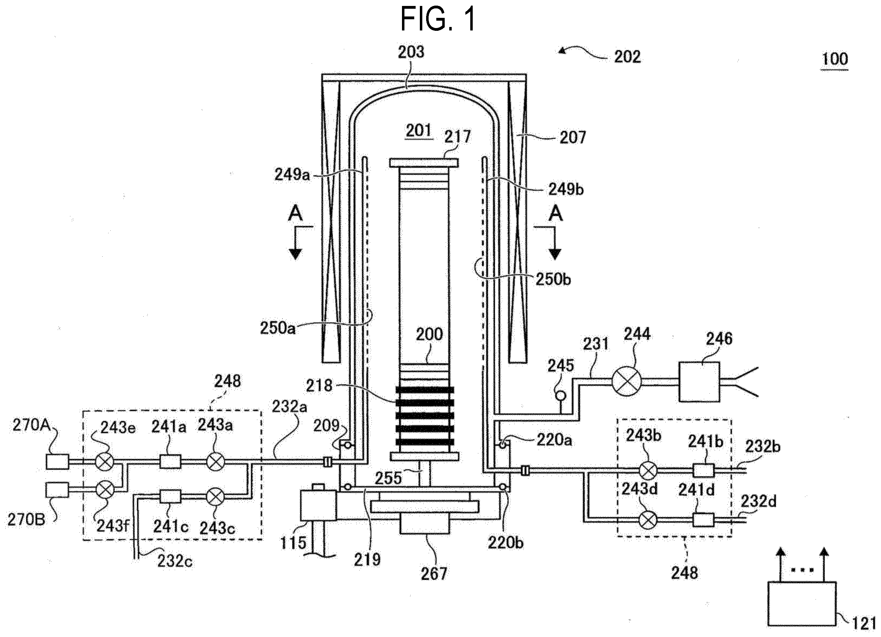

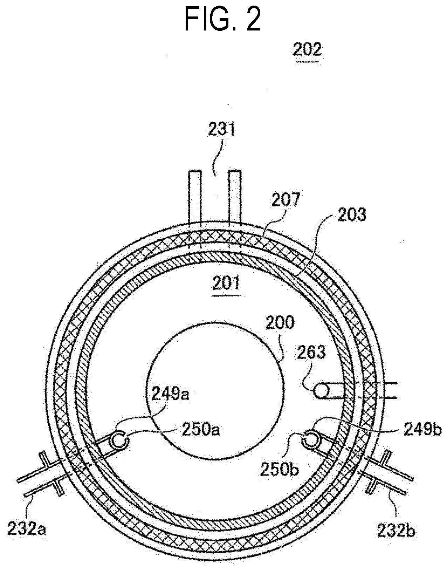

A configuration of a substrate processing apparatus 100 according to embodiments of the present disclosure will be described below with reference to FIGS. 1 and 2. The drawings used in the following description are schematic, and dimensional relationships, ratios, and the like of the respective components shown in the drawings may not match actual ones. Moreover, dimensional relationships, ratios, and the like of the respective components may not match one another among a plurality of drawings.

### (1) Configuration of Substrate Processing Apparatus

As shown in FIG. 1, a process furnace 202 includes a heater 207 as a heating system (temperature regulator). The heater 207 is formed in a cylindrical shape. The heater 207 also functions as an activator (exciter) configured to activate (excite) a gas by heat.

Inside the heater 207, a reaction tube 203 is placed concentrically with the heater 207. The reaction tube 203 is made of, for example, a heat-resistant material such as quartz (SiO₂) or silicon carbide (SiC) and is formed in a cylindrical shape with an upper end closed and a lower end open. Below the reaction tube 203, a manifold 209 is placed concentrically with the reaction tube 203. The manifold 209 is made of, for example, a metal such as stainless steel (SUS) and is formed in a cylindrical shape with upper and lower ends open. An upper end of the manifold 209 engages with a lower end of the reaction tube 203 and is configured to support the reaction tube 203. An O-ring 220a serving as a seal is provided between the manifold 209 and the reaction tube 203. Similar to the heater 207, the reaction tube 203 is installed vertically. A process container (reaction container) mainly includes the reaction tube 203 and the manifold 209. A process chamber 201 is formed in a hollow cylindrical region of the process container. The process chamber 201 is configured to be capable of accommodating wafers 200 as substrates.

Nozzles 249a and 249b are installed in the process chamber 201 to penetrate a sidewall of the manifold 209. Gas supply pipes 232a and 232b are connected to the nozzles 249a and 249b, respectively.

Two precursor containers 270A and 270B configured to be capable of accumulating a precursor (material) are connected to the gas supply pipe 232a via valves 243e and 243f, respectively. Therefore, the two precursor containers 270A and 270B, the valves 243e and 243f, which are open and close valves, a mass flow controller (MFC) 241a, which is a flow rate controller (flow rate control part), and a valve 243a are installed at the gas supply pipe 232a sequentially from an upstream side. Further, a mass flow controller (MFC) 241b, and a valve 243b, which is an open and close valve are installed at the gas supply pipe 232b sequentially from an upstream side. In addition, gas supply pipes 232c and 232d configured to supply an inert gas are connected to the gas supply pipes 232a and 232b at the downstream sides of the valves 243a and 243b, respectively. At the gas supply pipes 232c and 232d, MFCs 241c and 241d and valves 243c and 243d are installed sequentially from upstream sides, respectively.

The MFC 241a controls a flow rate of a precursor gas supplied to the process chamber 201, which is a process space in which the wafer 200 as a processing target is placed, by regulating an opening state of a control valve. Further, two pipes respectively being in fluid communication between the MFC 241a and the two precursor containers 270A and 270B are provided between the MFC 241a and the two precursor containers 270A and 270B. The two valves 243e and 243f, which are open and close valves, are provided at these two pipes, respectively.

As shown in FIG. 2, the nozzles 249a and 249b are respectively installed in an annular space (in a plane view) between an inner wall of the reaction tube 203 and the wafers 200 to extend upward from a lower side to an upper side of the inner wall of the reaction tube 203, that is, along an arrangement direction of the wafers 200. Gas supply holes 250a and 250b configured to supply a gas as a material are provided at side surfaces of the nozzles 249a and 249b, respectively. The gas supply holes 250a and 250b are open toward a center of the reaction tube 203, making it possible to supply gases toward the wafer 200. A plurality of gas supply holes 250a and 250b are provided from a lower side to an upper side of the reaction tube 203.

From the gas supply pipe 232a, a precursor gas as a material passing through the valves 243e and 243f from the precursor containers 270A and 270B is supplied into the process chamber 201 via the MFC 241a, the valve 243a, and the nozzle 249a.

From the gas supply pipe 232b, a reactant gas (material), for example, a nitrogen-containing gas, which reacts with the precursor gas is supplied into the process chamber 201 via the MFC 241b, the valve 243b, and the nozzle 249b. A reducing gas may be used as the reactant gas.

From the gas supply pipes 232c and 232d, an inert gas is supplied into the process chamber 201 via the MFCs 241c and 241d, the valves 243c and 243d, the gas supply pipes 232a and 232b, and the nozzles 249a and 249b, respectively.

A precursor gas supply system mainly includes the precursor containers 270A and 270B, the valves 243e and 243f, the gas supply pipe 232a, the MFC 241a, and the valve 243a. A reactant gas supply system mainly includes the gas supply pipe 232b, the MFC 241b, and the valve 243b. The precursor gas supply system and the reactant gas supply system may also be collectively referred to as a gas supply system. An inert gas supply system mainly includes the gas supply pipes 232c and 232d, the MFCs 241c and 241d, and the valves 243c and 243d. The inert gas supply system may be included in the gas supply system. The reactant gas supply system may also be referred to as a reducing gas supply system.

One or the entirety of the various supply systems described above may be constituted as an integrated supply system 248 in which the valves 243a to 243f, the MFCs 241a to 241d, and so on are integrated. The integrated supply system 248 is connected to each of the gas supply pipes 232a to 232d and is configured such that supply operations of various gases in the gas supply pipes 232a to 232d, i.e., opening and closing operations of the valves 243a to 243d, flow rate regulation operations by the MFCs 241a to 241d, and the like are controlled by a controller 121 described later.

The reaction tube 203 is provided with an exhaust pipe 231 configured to exhaust an inner atmosphere of the process chamber 201. A vacuum pump 246 as a vacuum exhauster is connected to the exhaust pipe 231 via a pressure sensor 245 as a pressure detector (pressure detection part) configured to detect an internal pressure of the process chamber 201 and an auto pressure controller (APC) valve (or a regulation valve) 244 as a pressure regulator (pressure regulation part). The APC valve 244 is configured to be capable of performing or stopping a vacuum exhaust operation of an inside of the process chamber 201 by being opened or closed while the vacuum pump 246 is in operation, and is also configured to be capable of regulating the internal pressure of the process chamber 201 by adjusting an opening state of the valve based on pressure information detected by the pressure sensor 245 while the vacuum pump 246 is in operation. An exhaust system mainly includes the exhaust pipe 231, the APC valve 244, and the pressure sensor 245. The exhaust system may include the vacuum pump 246.

A seal cap 219 as a furnace opening lid configured to be capable of airtightly closing a lower end opening of the manifold 209 is provided below the manifold 209. The seal cap 219 is made of, for example, a metal such as SUS and is formed in a disc shape. An O-ring 220b serving as a seal, which comes into contact with a lower end of the manifold 209, is provided at an upper surface of the seal cap 219. A rotator 267 configured to rotate a boat 217, which will be described later, is installed below the seal cap 219. A rotating shaft 255 of the rotator 267 is connected to the boat 217 through the seal cap 219. The rotator 267 is configured to rotate the wafer 200 by rotating the boat 217. The seal cap 219 is configured to be vertically raised or lowered by a boat elevator 115 as an elevator installed outside the reaction tube 203. The boat elevator 115 is configured to be capable of loading the boat 217 into the process chamber 201 or unloading the boat 217 out of the process chamber 201 by raising or lowering the seal cap 219. The boat elevator 115 is constituted as a transporter (transport equipment) configured to transport the boat 217, i.e., the wafer 200, into or out of the process chamber 201.

The boat 217, which serves as a substrate support, is configured to support a plurality of wafers 200, for example, 25 to 200 wafers 200 in such a state that the wafers 200 are arranged in a horizontal posture with the centers of the wafers 200 aligned with one another. That is, the boat 217 is configured to arrange the wafers 200 to be spaced apart from each other. The boat 217 is made of, for example, a heat-resistant material such as quartz or SiC. Heat insulating plates 218 made of, for example, a heat-resistant material such as quartz or SiC are installed in multiple stages at the lower side of the boat 217. The notation of a numerical range such as "25 to 200 sheets" in the present disclosure means that a lower limit value and an upper limit value are included in the range. Therefore, for example, "25 to 200 sheets" means "25 or more sheets but 200 or less sheets". The same applies to other numerical ranges.

A temperature sensor 263 as a temperature detector is installed inside the reaction tube 203. Based on temperature information detected by the temperature sensor 263, a state of supplying electric power to the heater 207 is regulated such that a temperature distribution in the process chamber 201 becomes a desired temperature distribution. The temperature sensor 263 is formed in an L-shape and is provided along the inner wall of the reaction tube 203.

### (Precursor Container)

Each of the precursor containers 270A and 270B includes a heating part such as a heater configured to heat precursor such as a liquid precursor or a solid precursor, which is accommodated in each of the precursor containers 270A and 270B. Here, the liquid precursor is a precursor that exists as liquid at room temperature and ambient pressure, and the solid precursor is a precursor that exists as solid at room temperature and ambient pressure. The controller 121 is configured to be capable of controlling temperatures of the two precursor containers 270A and 270B to be temperatures equal to or higher than vaporization temperatures of the precursors in the two precursor containers 270A and 270B respectively by the heating of the heater. A precursor gas of a gaseous state generated through phase change under such control is supplied to the process chamber 201 via the valves 243e and 243f, the MFC 241a, the valve 243a, and the nozzle 249a.

The precursor containers 270A and 270B are constituted as precursor tanks configured to accommodate the solid precursor. In this case, the solid precursors placed in the precursor containers 270A and 270B, which are the precursor tanks, are heated by the heater, sublimated, and then supplied to the process chamber 201 as a precursor gas in a gaseous state. When liquid precursors are used, the precursor containers 270A and 270B are constituted as vaporizers. In this case, the precursor containers 270A and 270B are heated by the heater, such that the accommodated liquid precursors are vaporized, and precursor gas in a gaseous state is supplied to the process chamber 201. Further, a gas in which an inert gas as a carrier gas or a regulating gas is mixed with the precursor gas is also included in a processing gas. Although no particular description is given, the precursors accommodated in the precursor containers 270A and 270B also include precursor gases, which are in a gaseous state at room temperature.

### (Flow Rate Controller)

Next, a configuration of the MFC 241a shown in FIG. 1 will be described. The MFC includes a flow rate sensor and a flow rate controller. The MFC is generally classified into a "thermal MFC" and a "pressure MFCs" according to difference in the flow rate sensor. The thermal MFC converts a temperature change caused by fluid flowing through the sensor into a mass flow rate, and the pressure MFC converts a pressure difference caused by fluid flowing through the sensor into a mass flow rate. The mass flow rate obtained in this way is compared with a flow rate set by a user, and the opening state of the valve (control valve) is regulated to be the set flow rate by feedback control such as PID control.

Further, the MFC (flow rate controller) may be provided with a function of externally outputting the opening state of the valve as an electric signal during flow rate control. Such a valve opening state signal is input to the controller as an electrical signal such as a voltage signal, and calculation of converting the electrical signal into an opening state (%) is performed, thereby grasping the opening state.

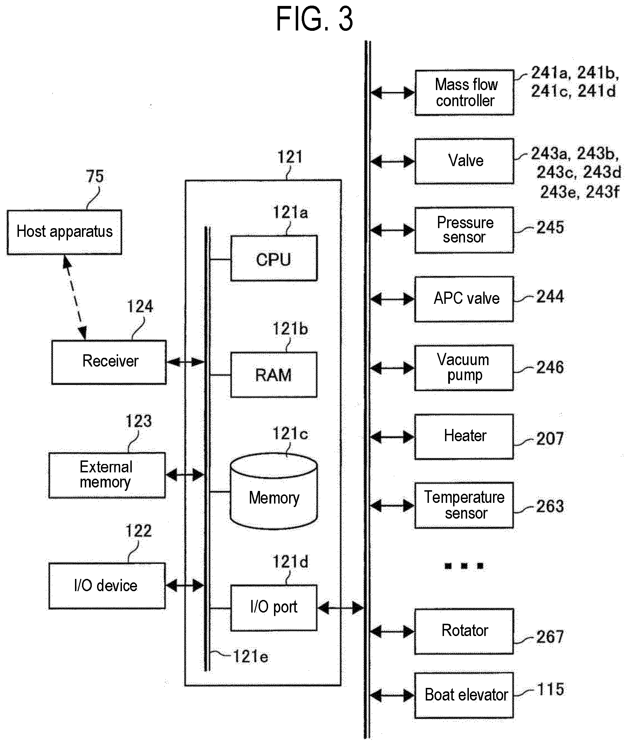

Next, the controller 121, which is a control part (control means or unit), will be described. As shown in FIG. 3, the controller 121, which is a control part (control means or unit), is constituted as a computer including a central processing unit (CPU) 121a, a random access memory (RAM) 121b, a memory 121c, and an input/output (I/O) port 121d. The RAM 121b, the memory 121c, and the I/O port 121d are configured to be capable of exchanging data with the CPU 121a via an internal bus 121e. An I/O device 122 implemented as, for example, a touch panel, is connected to the controller 121.

The memory 121c is constituted by, for example, a flash memory, a hard disk drive (HDD), or the like. The memory 121c readably stores a control program that controls an operation of the substrate processing apparatus 100 or a process recipe in which a substrate processing procedure or condition, which will be described later, is written. The process recipe is a combination that causes the controller 121 to execute each procedure in substrate processing described later to obtain a predetermined result and functions as a program. Hereinafter, a process recipe or a control program will be collectively referred to simply as a program. Further, the process recipe is also referred to simply as a recipe. In the present disclosure, the term "program" may indicate a recipe, a control program, or both. The RAM 121b is constituted as a memory area (work area) in which a program or data read by the CPU 121a is temporarily stored.

The I/O port 121d is connected to the above-described components, such as the MFCs 241a to 241d, the valves 243a to 243f, the pressure sensor 245, the APC valve 244, the vacuum pump 246, the heater 207, the temperature sensor 263, the rotator 267, and the boat elevator 115.

The CPU 121a is configured to read the control program from the memory 121c and execute the read control program. In addition, the CPU 121a is configured to read the recipe from the memory 121c according to an operation command input from the I/O device 122. According to contents of the read recipe, the CPU 121a is configured to control various operations such as flow rate regulating operations for various gases by the MFCs 241a to 241d, opening and closing operations of the valves 243a to 243f, an opening and closing operation of the APC valve 244, a pressure regulating operation by the APC valve 244 based on the pressure sensor 245, start and stop of the vacuum pump 246, a temperature regulating operation of the heater 207 based on the temperature sensor 263, rotation and rotation speed adjusting operations of the boat 217 by the rotator 267, and an elevating operation of the boat 217 by the boat elevator 115.

The controller 121 may be configured by installing the above-mentioned program stored in an external memory 123 (e.g., a magnetic disk such as a hard disk, an optical disc such as a CD, a magneto-optical disc such as an MO, or a semiconductor memory such as a USB memory) into a computer. The memory 121c or the external memory 123 is constituted by a computer-readable recording medium that records the program. Hereinafter, the memory 121c or the external memory 123 will be collectively referred to simply as a recording medium. The term "recording medium" used in the present disclosure may include the memory 121c, the external memory 123, or both. The program may be provided to the computer by using communication means or unit such as the Internet or a dedicated line, without using the external memory 123. Further, the controller 121 is provided with a receiver 124 connected to a host apparatus 75 via a network. The receiver 124 may receive information about other devices from the host apparatus 75.

### <Method of processing a substrate>

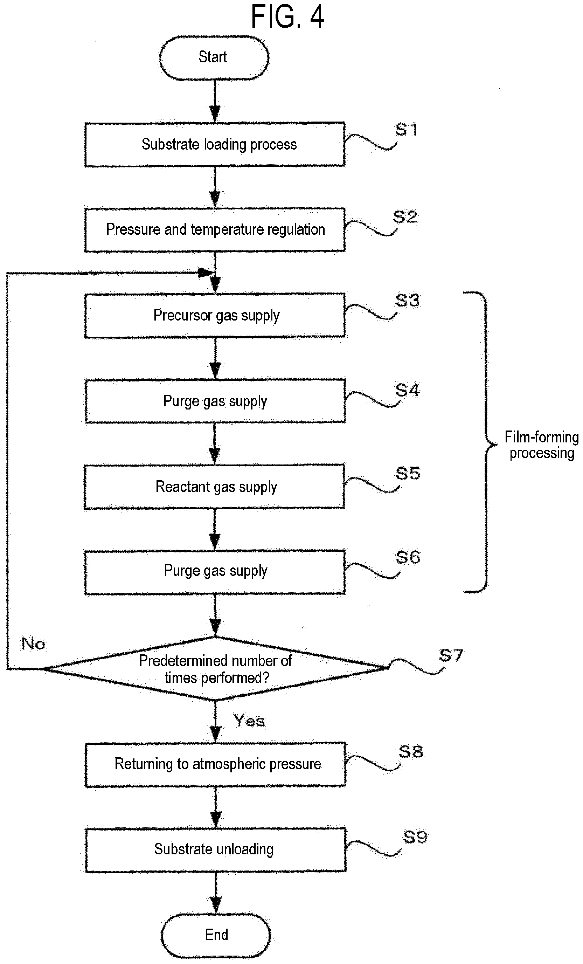

Next, a method of processing a substrate by using the substrate processing apparatus 100 according to some embodiments of the present disclosure will be described with reference to a flowchart of FIG. 4. As an example of a process of manufacturing a semiconductor device, a cycle process in which processing is performed by alternately supplying a source gas (precursor gas) and a reactant gas to the process chamber 201 is described. In the embodiments, an example in which a film is formed over the wafer 200 is described.

The term "wafer" used in the present disclosure may mean the wafer itself, or a stacked structure of a wafer and a predetermined layer or film formed over a surface of the wafer. The term "surface of wafer" used in the present disclosure may mean a surface of a wafer itself or a surface of a predetermined layer, etc. formed over the wafer. In the present disclosure, the expression "forming a predetermined layer over a wafer" refers to forming a predetermined layer directly on a surface of a wafer itself or forming a predetermined layer on a layer, etc. formed on a wafer. In the present disclosure, the term "substrate" used herein may be synonymous with the term "wafer."

In processing in the embodiments, a film is formed over the wafer 200 by performing, a predetermined number of times (one or more times), a cycle of non-simultaneously performing: a process of supplying a precursor gas to the wafer 200 in the process chamber 201 (film-forming process 1: step S3), a purge process of removing the precursor gas (residual gas) from the process chamber 201 (film-forming process 2: step S4), a process of supplying a reactant gas to the wafer 200 in the process chamber 201 (film-forming process 3: step S5), and a purge process of removing the reactant gas (residual gas) from the process chamber 201 (film-forming process 4: step S6).

First, as described above, the wafer 200 is loaded into the boat 217 and loaded into the process chamber 201 (step S1). In this case, after the boat 217 is loaded into the process chamber 201, pressure and temperature inside the process chamber 201 are regulated (step S2). Subsequently, four steps of film-forming processes 1 to 4 are sequentially performed. Each step will be described in detail below.

### (Film-Forming Process 1)

In the film-forming process 1, first, a precursor gas is adsorbed to the surface of the wafer 200. Specifically, in the precursor gas supply system (precursor gas supply line), the valve 243a is opened, and the precursor gas, a flow rate of which is controlled by the MFC 241a, is supplied to the process chamber 201.

### (Film-Forming Process 2)

Next, in the film-forming process 2, the valve 243a of the precursor gas supply system and the valve 243c of the inert gas supply system are closed to stop the supply of the precursor gas and the inert gas. The APC valve 244 of the exhaust pipe 231 is kept open, and the process furnace 202 is exhausted by using the vacuum pump 246 such that a pressure of the process furnace 202 becomes equal to or lower than a predetermined value, and a residual precursor gas is removed from the process chamber 201. Further, in this case, when an inert gas, such as N₂, is supplied to the process furnace 202, an effect of removing the residual precursor gas is further enhanced.

### (Film-Forming Process 3)

In the film-forming process 3, a reactant gas and an inert gas flow into the process chamber 201. First, both the valve 243b provided at the gas supply pipe 232b and the valve 243d provided at the gas supply pipe 232d are opened, and the reactant gas, a flow rate of which is regulated by the MFC 241b, from the gas supply pipe 232b, and the inert gas, a flow rate of which is regulated by the MFC 241d, from the gas supply pipe 232d, are mixed. The mixed gas is exhausted from the exhaust pipe 231 while being supplied to the process chamber 201 from the gas supply hole 250b of the nozzle 249b. By supplying the reactant gas, a film on a base film of the wafer 200 reacts with the reactant gas to form a predetermined film over the wafer 200.

### (Film-Forming Process 4)

In the film-forming process 4, after forming the film over the wafer 200, the valves 243b and 243d are closed, and the process chamber 201 is vacuum-exhausted by using the vacuum pump 246 as an exhauster to remove the reactant gas remaining after contributing to film formation. Further, in this case, in a case where the inert gas, such as N₂, is supplied to the process chamber 201, an effect of removing the remaining reactant gas from the process chamber 201 is enhanced.

A cycle of the film-forming processes 1 to 4 is performed a predetermined number of times in step S7, and then a film of a predetermined thickness may be formed over the wafer 200. In the embodiments, the film-forming processes 1 to 4 are performed multiple times.

After film-forming processing described above is completed, in step S8, a pressure of the process chamber 201 is returned to ambient pressure (atmospheric pressure). Specifically, for example, the inert gas, such as N₂ gas, is supplied to the process chamber 201 and exhausted. As a result, the process chamber 201 is purged with the inert gas, and a residual gas in the process chamber 201 is removed from the process chamber 201 (inert gas purge). Thereafter, the atmosphere of the process chamber 201 is replaced with the inert gas (inert gas replacement), and the pressure of the process chamber 201 is returned to ambient pressure (atmospheric pressure). Then, in step S9, in a case where the wafer 200 is unloaded out of the process chamber 201, substrate processing according to the embodiments is completed.

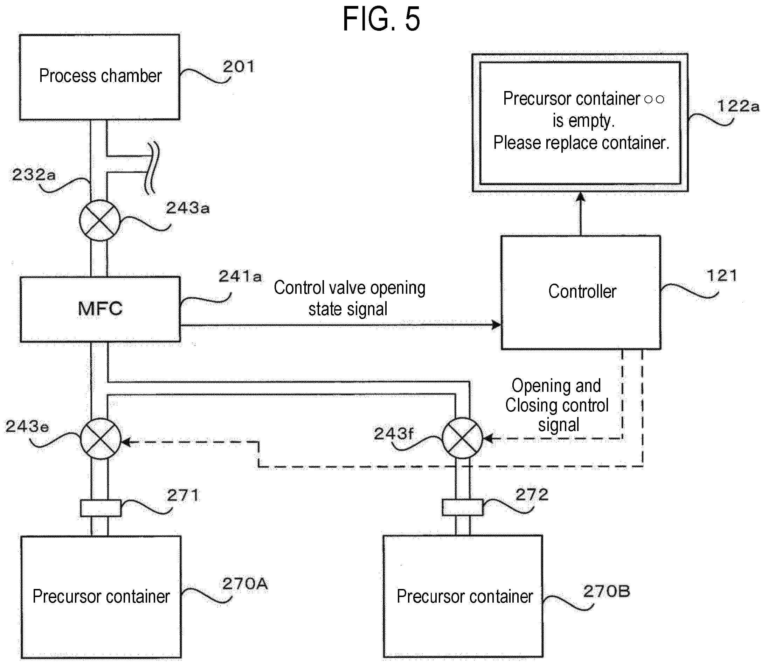

Next, a configuration of the precursor monitoring system in the embodiments will be described based on FIG. 5. FIG. 5 shows the configuration of the precursor monitoring system of the embodiments.

In a case where a precursor gas is supplied to the process chamber 201 from one precursor container, when there is no remaining precursor gas in the precursor container, the precursor container may be replaced with another precursor container filled with the precursor gas. However, while the precursor container is being replaced, the supply of the precursor gas to the process chamber 201 may be interrupted. Further, in a case where a shortage of the precursor gas supply occurs at an unexpected timing, this hinders film-forming processing and causes defects in film formation.

Therefore, the two precursor containers 270A and 270B are connected to the gas supply pipe 232a. Connectors 271 and 272 for separating the precursor containers 270A and 270B from the precursor gas supply system are provided between the precursor container 270A and the MFC 241a and between the precursor container 270B and the MFC 241a, respectively. By releasing the connectors 271 and 272, the precursor containers 270A and 270B may be separated from the precursor gas supply system. Therefore, when there is no remaining precursor gas in the precursor container 270A and the precursor container 270A becomes empty, the connector 271 is released while the valve 243e is being closed. Then, the precursor container 270A, which is empty, may be separated and replaceable while the precursor gas is being supplied from the precursor container 270B. The connectors 271 and 272 are omitted and not shown in FIG. 1.

In the embodiments, while a configuration in which the precursor gas is supplied to the process chamber 201 by using the two precursor containers 270A and 270B is shown, the number of precursor containers may be three or more.

Further, even in a case where the precursor gas is supplied to the process chamber 201 by using the two precursor containers 270A and 270B, when one precursor container is empty and then the supply of the precursor gas from the other precursor container is started, the supply of the processing gas will be interrupted. In a configuration in which a precursor gas of a predetermined flow rate controlled by the MFC 241a, is supplied to the process chamber 201, the opening state of the control valve of the MFC 241a increases as a remaining amount of the precursor gas in the precursor container decreases.

Therefore, in the embodiments, opening state information of the control valve in the MFC 241a is introduced to the controller 121 as a control valve opening state signal. Then, the controller 121 acquires information indicating the opening state of the control valve from such opening state information and compares the opening state of the control valve acquired from the opening state information with a preset threshold. In a case where it is determined that the opening state of the control valve reaches the threshold, the controller 121 determines that the remaining amount of the precursor gas in one precursor container is equal to or less than a predetermined amount and that the remaining amount will be insufficient in the near future. Then, the controller 121 may perform a notification on a displayer 122a and starts the supply of the precursor gas from the other precursor container.

A display screen displayed on the displayer 122a is an example of a display screen displayed on the I/O device 122 shown in FIG. 3. Further, such a display screen may be displayed on the host apparatus 75 shown in FIG. 3.

Specifically, when the opening state of the control valve in the MFC 241a does not reach the preset threshold, the controller 121 supplies the precursor gas from one of the two precursor containers 270A and 270B via the MFC 241a to the process chamber 201, which is a process space.

When the opening state of the control valve of the MFC 241a reaches the threshold, the controller 121 opens the valve 243e or the valve 243f provided between the MFC 241a and the precursor container different from the precursor container which is supplying the precursor to supply the precursor gas to the process chamber 201 from among the two precursor containers via the MFC 241a. When three or more precursor containers are used, the controller 121 controls the precursor gas to be supplied to the process chamber 201 from two or more precursor containers among the precursor containers.

In the embodiments, even in a case where the remaining amount of the precursor gas in one precursor container becomes small, the precursor gas in the other precursor container is simultaneously supplied to the process chamber 201 in which the wafer 200 to be processed is placed. In addition, an empty precursor container may be replaced while the precursor gas is being supplied to the process chamber 201 from a precursor container with a large remaining amount of the precursor gas. Therefore, according to the embodiments, it is possible to prevent the supply of the precursor gas from becoming unstable, such as interruption in the supply of the precursor gas. Further, since the precursor gas may be stably supplied, substrate processing may be continued.

Here, the above-described threshold is set to an opening state at which the MFC 241a is capable of supplying the precursor gas to the process chamber 201 at a set flow rate when the precursor gas is supplied to the MFC 241a from one of the two precursor containers 270A and 270B. For example, in a case where the remaining amount of the precursor gas in the precursor container decreases and then the opening state of the control valve increases to exceed 90%, such that the set flow rate cannot be maintained for a predetermined time, the threshold of the opening state may be set to, for example, a value such as 80% or 85%.

Alternatively, the threshold may be set to an opening state of the control valve in a state from ten seconds to several tens of seconds prior to a timing at which the opening state of the control valve becomes 100%, which is a maximum value, when the precursor gas is supplied from one of the two precursor containers 270A and 270B to the MFC 241a.

Further, the above-described threshold may be set to an opening state of the control valve in a state before an amount of decrease per unit time when the pressure in a precursor container which is supplying the precursor gas to the MFC 241a decreases becomes a preset value or more, when the precursor gas is supplied to the MFC 241a from one of the two precursor containers 270A and 270B.

By setting the threshold as described above, a threshold for comparison with the opening state of the control valve is set based on data obtained when the precursor gas is actually supplied from one precursor container. Therefore, it becomes possible to stably and continuously supply the precursor gas to the process chamber 201.

Further, when the opening state of the control valve of the MFC 241a reaches the threshold, the controller 121 notifies the user that the opening state of the control valve of the MFC 241a reaches the threshold by displaying the notification on the displayer.

As described above, according to such a configuration in which the user is notified that the opening state of the control valve of the MFC 241a reaches the threshold, the user may grasp a state in which maintenance such as replacement is demanded due to a small amount of the precursor gas remaining in the precursor container.

Further, the controller 121 may notify that it is time to replace a precursor container which is supplying the precursor gas to the MFC 241a when the opening state of the control valve of the MFC 241a reaches the threshold among the two precursor containers 270A and 270B, after a predetermined time elapses after the opening state of the control valve of the MFC 241a reaches the threshold.

According to the above-described configuration, since the user may grasp when to replace a precursor container, instability in supply of the precursor gas is eliminated and the precursor gas is stably and continuously supplied to the process chamber 201.

The substrate processing apparatus 100 of the embodiments may be configured to further include a displayer configured to display that the opening state of the control valve of the MFC 241a reaches the threshold. An example of a display screen displayed on the displayer is shown in FIG. 5. In FIG. 5, an example of a display screen that urges replacement of a precursor container is shown on the displayer 122a.

According to the above-described configuration, the user is informed that the opening state of the control valve of the MFC 241a exceeds the threshold through the display. Therefore, the user may grasp that maintenance such as replacement of a precursor container is demanded by viewing the display screen of the displayer.

As shown in FIG. 5, the two precursor containers 270A and 270B are connected to pipes between the MFC 241a and the precursor containers 270A and 270B via the connectors 271 and 272, respectively. The controller 121 determines that a precursor container, which is supplying the precursor gas to the MFC 241a when the opening state of the control valve reaches the threshold among the two precursor containers 270A and 270B, is an empty container in which an amount of the precursor gas is equal to or below a predetermined amount. Then, the controller 121 closes the valve (either the valve 243e or the valve 243f) between the empty container and the MFC 241a to enable the empty container to be separated.

Further, the controller 121 closes the valve (either the valve 243e or the valve 243f) between the empty container and the MFC 241a when the precursor gas is not supplied from the MFC 241a to the process chamber 201 after the opening state of the control valve of the MFC 241a reaches the threshold.

Alternatively, the controller 121 closes the valve (either the valve 243e or the valve 243f) between the empty container and the MFC 241a when predetermined precursor supply processing is ended after the opening state of the control valve of the MFC 241a reaches the threshold.

According to such a configuration, supply of the precursor gas and replacement of the precursor containers may be performed in parallel. Therefore, a state in which the supply of the precursor gas to the process chamber 201 becomes unstable, such as interruption in the supply of the precursor gas to the process chamber 201, may be prevented and the precursor gas may be stably and continuously supplied to the process chamber 201.

Further, as described above, each of the two precursor containers 270A and 270B includes a heater configured to heat the precursor contained therein. By the heating of the heaters, the controller 121 may control temperatures of the two precursor containers 270A, 270B to temperatures equal to or higher than vaporization temperatures of the precursors in the two precursor containers 270A and 270B, respectively.

Further, a heating equipment may be further provided to heat the precursor gas supply system including a plurality of pipes between the two precursor containers 270A and 270B and the MFC 241a, the MFC 241a, and the valves 243e and 243f. The heating equipment is temperature-controlled to heat the precursor gas supply system to a temperature equal to or higher than a vaporization temperature of the precursor gas.

According to such a configuration, since the precursor gas is maintained at the vaporization temperature in the precursor gas supply system configured to supply the precursor gas to the process chamber 201, it is possible to suppress occurrence of particles caused by deposition of attachments when the precursor gas is re-solidified (re-liquefied) and attaches to the pipe.

Further, the controller 121 is configured to be capable of opening the APC valve 244 provided at the exhaust pipe 231, which is an exhaust side pipe of the process chamber 201, even while supplying the precursor gas to the process chamber 201.

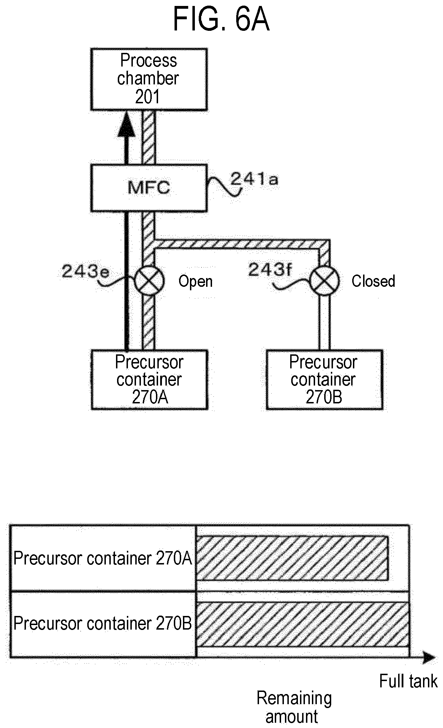

Next, an operation of the precursor monitoring system in the embodiments will be described with reference to FIGS. 6A to 6C.

FIG. 6A is a diagram showing a state at the start of supply of a precursor gas. In FIG. 6A, the valve 243e is in an open state, the valve 243f is in a closed state, and the precursor gas is supplied to the process chamber 201 from the precursor container 270A via the MFC 241a. In addition, in FIG. 6A, the precursor container 270B is a full tank. The precursor container 270B may not be full at this point, and the precursor container 270B may be full or filled with a sufficient remaining amount before the precursor container 270A is replaced.

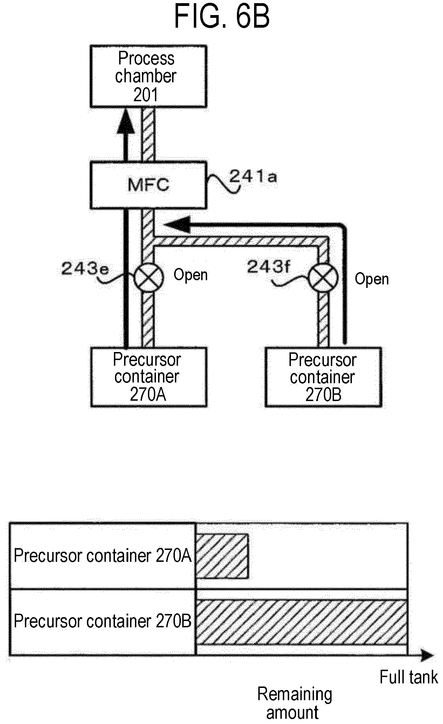

FIG. 6B is a diagram showing a state in which the remaining amount of the precursor container 270A decreases from a state of FIG. 6A and the opening state of the control valve of the MFC 241a exceeds a threshold. When the opening state of the control valve exceeds the threshold, the controller 121 changes the valve 243f from the closed state to the open state. Therefore, the supply of the precursor gas is also started from the precursor container 270B, and in this state, the precursor gas is simultaneously supplied to the process chamber 201 from the two precursor containers 270A and 270B. At this point, the remaining amount of the precursor container 270A is kept at a certain amount, and a set flow rate is maintained in the MFC 241a even before the valve 243f is open.

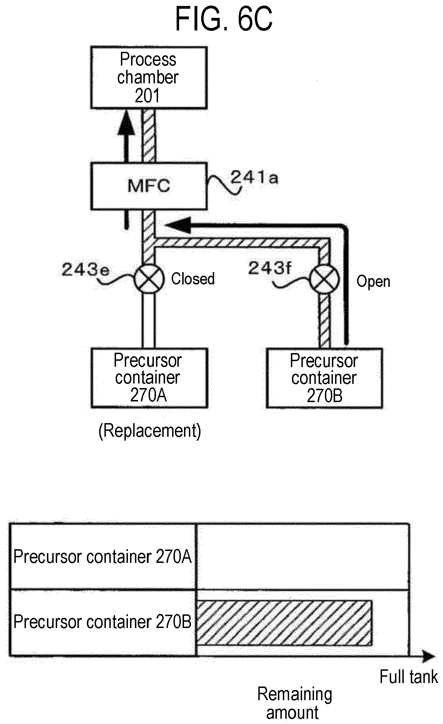

FIG. 6C is a diagram showing a state when a predetermined time elapses from the state of FIG. 6B. In FIG. 6C, the controller 121 changes the valve 243e from the open state to the closed state. Therefore, the precursor gas is supplied to the process chamber 201 from the precursor container 270B. At this point, it may be appreciated that the remaining amount of the precursor gas in the precursor container 270A is almost zero, indicating that the precursor container 270A is in an empty state. The precursor container 270A in an empty state is in a state of replacement standby and is replaced with a precursor container which is full in parallel with the supply of the precursor gas by the precursor container 270B.

By repeating the state transition shown in FIGS. 6A to 6C, the supply of the precursor gas is started from one of the two precursor containers 270A and 270B. When the one precursor container approaches the empty state, the supply of the precursor gas is started from the other precursor container as well. Then, the valve of the one precursor container is closed. In a case where the one precursor container is replaced with a precursor container which is full, the same transition is repeated. As a result, the processing gas is continuously supplied to the process chamber 201 without interruption.

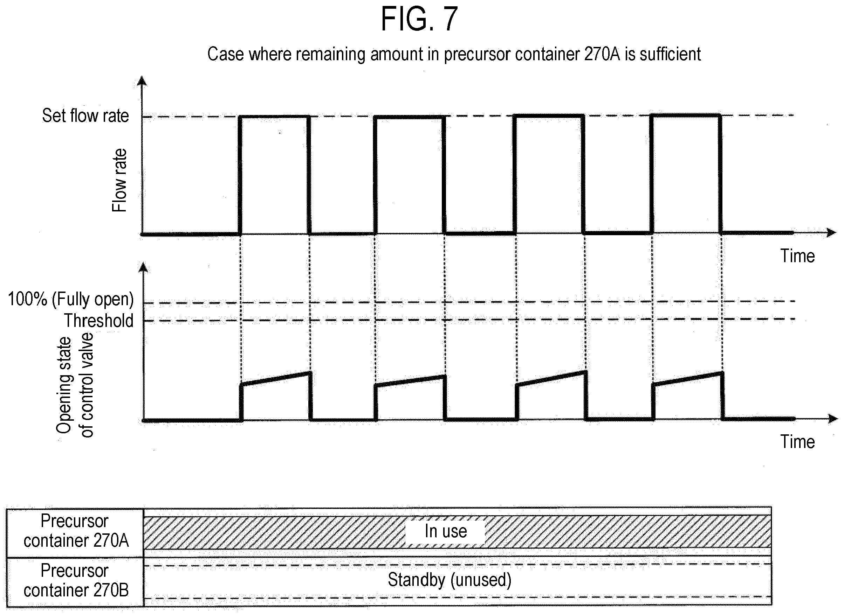

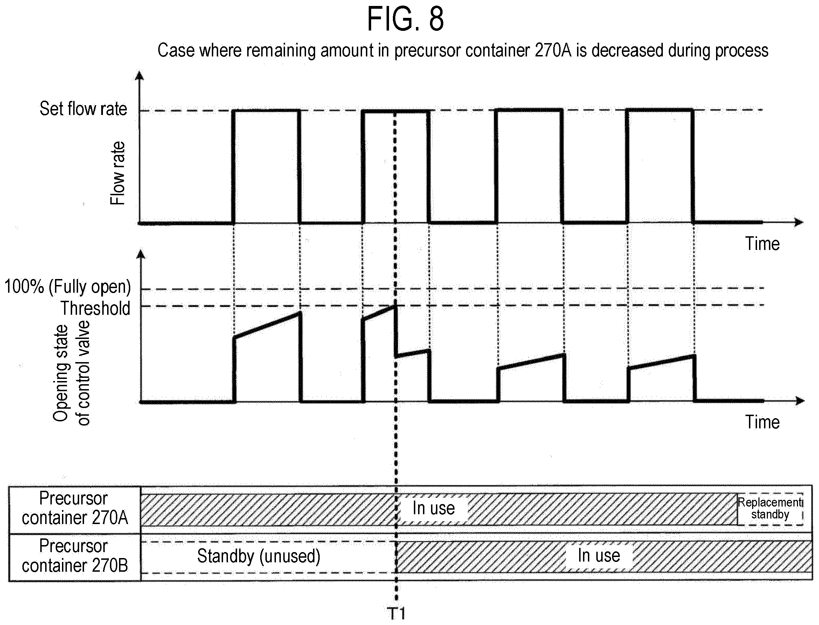

Next, flow control in the precursor monitoring system in the embodiments will be described based on FIGS. 7 and 8.

First, a relationship between the flow rate of a precursor gas and the sensitivity of a control valve of the MFC 241a when the remaining amount of the precursor gas in the precursor container 270A is sufficient is shown in FIG. 7.

In FIG. 7, in the upper graph, a vertical axis represents the flow rate of the precursor gas, and a horizontal axis represents time. In the lower graph, a vertical axis represents the opening state of the control valve of the MFC 241a, and a horizontal axis represents time.

Here, a set flow rate is a flow rate controlled by the MFC 241a and is a flow rate that is preset according to a process and a film type. In a case where such a set flow rate cannot be maintained, film-forming processing may be stopped during the processing.

Further, a threshold of an opening state of the control valve is an index for determining a timing of switching from the supply of the precursor gas from one precursor container to the supply of the precursor gas from two precursor containers. When the opening state of the control valve is 100% (fully open), it indicates that the control valve is in a fully open state.

In FIG. 7, since the remaining amount of the precursor container 270A is sufficient, the opening state of the control valve does not reach the threshold. It may be appreciated that the precursor container 270A is in use, and the precursor container 270B is in a standby (unused) state.

FIG. 8 shows a case in which the remaining amount of the precursor container 270A decreases and approaches an empty state over time from the state shown in FIG. 7.

In FIG. 8, the opening state of the control valve of the MFC 241a increases as the remaining amount in the precursor container 270A decreases, and the opening state of the control valve reaches the threshold at time T1. Therefore, the controller 121 changes the valve 243f from a closed state to an open state at time T1, and starts supplying the precursor gas from the precursor container 270B. Therefore, after the time T1, the precursor container 270B also changes from a standby (unused) state to an in-use state, and the precursor gas is supplied from both of the precursor containers 270A and 270B. As a result, the opening state of the control valve in the MFC 241a becomes smaller due to the sufficient supply of the precursor gas.

Thereafter, when a process recipe in film-forming processing is completed, the controller 121 changes the valve 243e from the open state to the closed state and stops supplying the precursor gas from the precursor container 270A. Thereafter, the precursor gas is supplied from the precursor container 270B, and the precursor container 270A is in a state of replacement standby.

In FIG. 7, since the remaining amount of the precursor in the precursor container 270A is sufficient, a sublimation rate of the precursor is also sufficient, and a slope of the opening state of the control valve during the supply of the precursor gas is small and is not greatly changed. In contrast, in FIG. 8, it may be appreciated that, since the remaining amount of precursor in the precursor container 270A is small, a slope of the opening state of the control valve during the supply of the precursor gas is increased. In FIG. 8, after the time T1, since the precursor gas is supplied from the two precursor containers 270A and 270B, the slope of the opening state of the control valve becomes smaller and is about the same as the slope in FIG. 7.

In the embodiments, when the remaining amount of the precursor in the precursor container 270A becomes small due to the supply of the precursor gas from the precursor container 270A, the precursor gas is also supplied from the precursor container 270B and the precursor container 270A is replaced while the precursor gas is being supplied by the precursor container 270B with a sufficient remaining amount of the precursor. Therefore, it is possible to achieve replacement of a precursor container while suppressing fluctuations in the flow rate of a processing gas supplied to the process chamber 201.

### (Other Embodiments)

While the embodiments of the present disclosure are described above in detail, the present disclosure is not limited to the above-described embodiments, and various changes may be made without departing from the scope of the present disclosure.

For example, in the above-described embodiments, the film-forming processing performed by the substrate processing apparatus is configured to use a solid precursor as a precursor source and generate a precursor gas by heating and sublimating the solid precursor. Although the example in which a nitrogen-containing gas is used as the reactant gas and the precursor gas and the nitrogen-containing gas are alternately supplied to form a nitride film over the wafer 200 is described above, the present disclosure is not limited to this case.

Further, as the solid precursor, a solid precursor chemical substance, in particular, an inorganic solid precursor metal or a semiconductor precursor may be used. For example, HfCl₄, ZrCl₄, AlCl₃, MoO₂Cl₂, MoCls, or SiI₄ may be used as the solid precursor.

Further, the embodiment is also applicable to a case in which a precursor supplied in a liquid state is heated and vaporized to generate the precursor gas. Examples of such a liquid precursor gas may include a chlorosilane-based gas such as monochlorosilane (SiH₃Cl, abbreviation: MCS) gas, dichlorosilane (SiH₂Cl₂, abbreviation: DCS) gas, trichlorosilane (SiHCl₃, abbreviation: TCS) gas, tetrachlorosilane (SiCl₄, abbreviation: STC) gas, hexachlorodisilane (Si₂Cl₆, abbreviation: HCDS) gas, or octachlorotrisilane (Si₃Cl₈, abbreviation: OCTS) gas. Further, examples of the precursor gas may use a fluorosilane-based gas such as tetrafluorosilane (SiF₄) gas or difluorosilane (SiH₂F₂) gas, a bromosilane-based gas such as tetrabromosilane (SiBr₄) gas or dibromosilane (SiH₂Br₂) gas, or an iodosilane-based gas such as tetraiodosilane (SiI₄) gas or diiodosilane (SiH₂I₂) gas. Further, examples of the precursor gas may include an aminosilane-based gas such as tetrakis(dimethylamino)silane (Si[N(CH₃)₂]₄, abbreviation: 4DMAS) gas, tris(dimethylamino)silane (Si[N(CH₃)₂]₃H, abbreviation: 3DMAS) gas, bis(diethylamino)silane (Si[N(C₂H₅)₂]₂H₂, abbreviation: BDEAS) gas, or bis(tert-butylamino)silane (SiH₂[NH(C₄H₉)]₂, abbreviation: BTBAS) gas. Further, examples of the precursor gas may include organic silane precursor gas such as tetraethoxysilane (Si(OC₂H₅)₄, abbreviation: TEOS) gas. As the precursor gas, one or more of these gases may be used. In other words, a precursor stored in liquid form by pressurization or cooling may also be included.

As the nitrogen-containing gas, one or more selected from the group of nitrous oxide (N₂O) gas, nitrogen monoxide (NO) gas, nitrogen dioxide (NO₂) gas, and ammonia (NH₃) gas may be used.

Further, the reactant is not limited to the nitrogen-containing gas, and other types of thin films may be formed by using a gas that reacts with a source to process a film. Furthermore, film-forming processing may be performed by using three or more types of processing gases.

Further, for example, in each embodiment described above, while the film-forming processing in the semiconductor device is taken as an example of processing performed by the substrate processing apparatus, the present disclosure is not limited thereto. The technique of the present disclosure may be applied to processing performed by exposing a processing object on which a pattern is formed with a high aspect ratio (i.e., depth is larger than width) to a vaporized gas. That is, in addition to film-forming processing, processing of forming an oxide film or a nitride film or processing of forming a film containing a metal may be performed. Further, detailed contents of substrate processing is not limited, and the present disclosure may be suitably applied to film formation processing and to other substrate processing such as annealing processing, oxidation processing, nitriding processing, diffusion processing, and lithography processing.

Further, the present disclosure is suitably applicable to other substrate processing apparatuses such as an annealing processing apparatus, an oxidation processing apparatus, a nitridation processing apparatus, an exposure apparatus, a coating apparatus, a drying apparatus, a heating apparatus, and a processing apparatus using plasma. Further, in the present disclosure, these apparatuses may be used together.

Further, in the embodiments, while the semiconductor manufacturing process is described, the present disclosure is not limited thereto. For example, the present disclosure may also be applied to substrate processing such as a liquid crystal device manufacturing process, a solar cell manufacturing process, a light emitting device manufacturing process, a glass substrate processing process, a ceramic substrate processing process, and a conductive substrate processing process.

Furthermore, it is possible to replace a part of a configuration of one embodiment with a configuration of another embodiment, and it is also possible to add a configuration of one embodiment to a configuration of another embodiment. Further, with respect to a part of the configuration of each embodiment, addition of another configuration, deletion or replacement may be performed.

Further, while the above-described embodiments described the example in which N₂ gas is used as the inert gas, the present disclosure is not limited thereto, and a rare gas such as Ar gas, He gas, Ne gas, and Xe gas may also be used.

According to the present disclosure in some embodiments, it is possible to stably supply a material in a gaseous state to a process space.

While certain embodiments have been described, these embodiments have been presented by way of example only, and are not intended to limit the scope of the disclosures. Indeed, the embodiments described herein may be embodied in a variety of other forms. Furthermore, various omissions, substitutions and changes in the form of the embodiments described herein may be made without departing from the spirit of the disclosures. The accompanying claims and their equivalents are intended to cover such forms or modifications as would fall within the scope and spirit of the disclosures.

## Claims

1. A material monitoring system, comprising:
a plurality of containers (270A, 270B) configured to accumulate a material,
a flow rate controller (241a) configured to control a flow rate of the material supplied to a process space (201) in which a processing target (200) is placed by regulating an opening state of a control valve;
a plurality of pipes configured to be in fluid communication between the flow rate controller (241a) and the plurality of containers (270A, 270B) respectively;
a plurality of open and close valves (243e, 243f) provided at the plurality of pipes respectively, and
a controller (121) configured to be capable of supplying the material to the process space (201) via the flow rate controller (241a) from one container among the plurality of containers (270A, 270B) when the opening state of the control valve of the flow rate controller (241a) does not reach a preset threshold, and supplying the material to the process space (201) via the flow rate controller (241a) from two or more containers among the plurality of containers (270A, 270B) by opening the open and close valve provided between another container different from the one container and the flow rate controller (241a) when the opening state of the control valve of the flow rate controller (241a) reaches the preset threshold.

2. The material monitoring system of Claim 1, wherein the preset threshold is set to an opening state at which the flow rate controller (241a) is capable of supplying the material to the process space (201) at a set flow rate when the material is supplied to the flow rate controller (241a) from the one container among the plurality of containers (270A, 270B).

3. The material monitoring system of Claim 2, wherein the preset threshold is set to an opening state of the control valve in a state ranging from ten seconds to several tens of seconds prior to a timing at which the opening state of the control valve becomes a maximum opening state, when the material is supplied to the flow rate controller (241a) from the one container among the plurality of containers (270A, 270B).

4. The material monitoring system of Claim 2, wherein the preset threshold is set to an opening state of the control valve in a state before an amount of decrease per unit time when a pressure in a container which is supplying the material to the flow rate controller (241a) decreases becomes a preset value or more, when the material is supplied to the flow rate controller (241a) from the one container among the plurality of containers (270A, 270B).

5. The material monitoring system of Claim 1, wherein the controller (121) is configured to be capable of notifying that the opening state of the control valve reaches the preset threshold when the opening state of the control valve reaches the preset threshold.

6. The material monitoring system of Claim 1, wherein the controller (121) is configured to be capable of notifying that it is time to replace a container among the plurality of containers (270A, 270B) which is supplying the material to the flow rate controller (241a) when the opening state of the control valve reaches the preset threshold, after a predetermined time elapses since the opening state of the control valve reaches the preset threshold.

7. The material monitoring system of Claim 1, wherein the plurality of containers (270A, 270B) are respectively connected to the plurality of pipes via connectors (271, 272), and
wherein the controller (121) determines that a container among the plurality of containers (270A, 270B) which is supplying the material to the flow rate controller (241a) when the opening state of the control valve reaches the preset threshold is an empty container in which an amount of the material is a predetermined amount or less, and closes an open and close valve, among the open and close valves (243e, 243f), between the empty container and the flow rate controller (241a) to enable the empty container to be separated.

8. The material monitoring system of Claim 7, wherein the controller (121) is configured to be capable of closing the open and close valve between the empty container and the flow rate controller (241a) when the material is not supplied to the process space (201) from the flow rate controller (241a) after the opening state of the control valve of the flow rate controller (241a) reaches the preset threshold.

9. The material monitoring system of Claim 7, wherein the controller (121) is configured to be capable of closing the open and close valve between the empty container and the flow rate controller (241a) when a predetermined material supply process is ended after the opening state of the control valve of the flow rate controller (241a) reaches the preset threshold.

10. The material monitoring system of Claim 1, wherein each of the plurality of containers (270A, 270B) includes a heater configured to heat the material, and
wherein the controller (121) is configured to be capable of controlling, by the heating of the heater, a temperature of each of the plurality of containers (270A, 270B) to be equal to or higher than a vaporization temperature at which the material in each of the plurality of containers (270A, 270B) is transformed into a gaseous state.

11. The material monitoring system of Claim 1, further comprising a heating equipment configured to heat a material supply line including the plurality of pipes, the flow rate controller (241a), and the plurality of open and close valves (243e, 243f), and
wherein the heating equipment is temperature-controlled to heat the material supply line to a temperature equal to or higher than a vaporization temperature of the material.

12. The material monitoring system of Claim 1, wherein the controller (121) is configured to be capable of opening a regulation valve provided at an exhaust side pipe (231) of the process space (201) while supplying the material to the process space (201).

13. A processing apparatus, comprising the material monitoring system of Claim 1.

14. A method of manufacturing a semiconductor device, including a process of supplying a material to a surface of a processing target (200) placed in a process space (201), wherein the process comprises:
supplying the material to the process space (201) via a flow rate controller (241a), which is configured to control a flow rate of the material, from one container among a plurality of containers (270A, 270B) when an opening state of a control valve of the flow rate controller (241a) does not reach a preset threshold, and supplying the material to the process space (201) via the flow rate controller (241a) from two or more containers among the plurality of containers (270A, 270B) by opening an open and close valve provided between another container different from the one container and the flow rate controller (241a) when the opening state of the control valve of the flow rate controller (241a) reaches the preset threshold.

15. A program that causes a processing apparatus to perform a process comprising:
supplying a material to a process space (201) in which a processing target (200) is placed via a flow rate controller (241a) configured to control a flow rate of the material by regulating an opening state of a control valve, from one container among a plurality of containers (270A, 270B) configured to be capable of accumulating the material when the opening state of the control valve of the flow rate controller (241a) does not reach a preset threshold, and supplying the material to the process space (201) via the flow rate controller (241a) from two or more containers among the plurality of containers (270A, 270B) by opening an open and close valve provided between another container different from the one container and the flow rate controller (241a), among a plurality of open and close valves (243e, 243f) provided respectively at a plurality of pipes configured to be in fluid communication between the flow rate controller (241a) and the plurality of containers (270A, 270B) respectively, when the opening state of the control valve of the flow rate controller (241a) reaches the preset threshold.
